# EUROPÄISCHE PATENTSCHRIFT

(11) **EP 1 920 508 B1**
(45) Veröffentlichungstag und Bekanntmachung des Hinweises auf die Patenterteilung: **07.12.2016**
(21) Anmeldenummer: 06775815.1
(22) Anmeldetag: 07.08.2006
(51) Int. Cl.: H01L 33/00, H01S 5/02, H01L 33/32, H01S 5/323

(54) **VERFAHREN ZUM LATERALEN ZERTRENNEN EINES HALBLEITERSTAPELWAFERS**
METHOD FOR LATERAL SEPARATION OF A SEMICONDUCTOR WAFER STACK
PROCÉDÉ POUR SÉPARER LATÉRALEMENT UNE PLAQUETTE DE SEMI-CONDUCTEURS EMPILÉS

(30) Priorität: 01.09.2005 DE 102005041572; 02.11.2005 DE 102005052357
(43) Veröffentlichungstag der Anmeldung: 14.05.2008
(73) Patentinhaber: OSRAM Opto Semiconductors GmbH, 93055 Regensburg (DE)
(72) Erfinder: HÄRLE, Volker, 93164 Laaber (DE); EICHLER, Christoph, 93105 Tegernheim (DE)
(74) Vertreter: Epping - Hermann - Fischer
(86) Internationale Anmeldenummer: PCT/DE2006/001377
(87) Internationale Veröffentlichungsnummer: WO 2007/025499

(56) Entgegenhaltungen:
- EP-A- 0 994 503
- WO-A-2004/061943
- WO-A2-03/100839
- FR-A1- 2 758 907
- US-B1- 6 225 193

## Beschreibung

Diese Patentanmeldung beansprucht die Priorität der deutschen Patentanmeldungen 10 2005 052 357.9 und 10 2005 041 572.5

Die Erfindung betrifft ein Verfahren zum lateralen Zertrennen eines Halbleiterwafers, insbesondere eines Halbleiterwafers zur Herstellung von optoelektronischen Bauelementen.

Bei der Herstellung optoelektronischer Bauelemente, beispielsweise LEDs oder Halbleiterlasern, ist es oftmals wünschenswert, ein für das epitaktische Aufwachsen einer Halbleiterschichtenfolge des optoelektronischen Bauelements verwendetes Aufwachssubstrat nachträglich von dem Halbleiterwafer abzutrennen.

Beispielsweise wird bei der sogenannten Dünnfilm-Technologie zunächst die Halbleiterschichtenfolge eines optoelektronischen Bauelements epitaktisch auf einem Aufwachssubstrat aufgewachsen, anschließend ein Träger auf die dem Aufwachssubstrat gegenüberliegende Oberfläche der Halbleiterschichtenfolge aufgebracht und nachfolgend das Aufwachssubstrat abgetrennt. Dieses Verfahren hat einerseits den Vorteil, dass auf dem neuen Träger eine vergleichsweise dünne Epitaxieschichtenfolge verbleibt, aus der die von dem optoelektronischen Bauelement emittierte Strahlung mit hoher Effizienz ausgekoppelt werden kann, insbesondere wenn zwischen der Epitaxieschichtenfolge und dem neuen Träger eine reflektierende oder reflexionserhöhende Schicht vorgesehen ist. Weiterhin kann das Aufwachssubstrat nach dem Ablösen vorteilhaft wieder verwendet werden. Dies ist insbesondere dann von Vorteil, wenn das Aufwachssubstrat aus einem vergleichsweise hochwertigem Material, insbesondere Saphir, SiC oder GaN, besteht.

Bei der Verwendung eines transparenten Aufwachssubstrats aus Saphir kann das Ablösen des Aufwachssubstrats von der Epitaxieschichtenfolge beispielsweise mit einem aus der WO 98/14986 A1 bekannten Laser-Lift-Off-Verfahren erfolgen.

Dieser Verfahren ist allerdings nicht ohne weiteres auf Substrate aus einem Nitrid-Verbindungshalbleiter, insbesondere GaN, anwendbar.

Aus der Druckschrift US 6,815,309 B2 ist bekannt, eine dünne Schicht eines hochwertigen Substrats, zum Beispiel GaN, auf ein geringwertigeres Trägersubstrat zu übertragen.

Aus der Druckschrift US 5,374,564 A ist ein Verfahren zum Abtrennen einer dünnen Halbleiterschicht von einem Substrat bekannt, das auf der Implantation von Wasserstoffionen durch die abzulösende Schicht und einer nachfolgenden Temperaturbehandlung zur Erzeugung von Bläschen (Blistern) in dem ionenimplantierten Bereich, die ein thermisches Absprengen der abzulösenden Halbleiterschicht bewirkt, beruht.

Bei einer Anwendung dieses Verfahrens auf einen Halbleiterwafer, auf den bereits eine funktionelle Halbleiterschichtenfolge epitaktisch abgeschieden ist, besteht die Gefahr, dass die funktionelle Halbleiterschichtenfolge bei der Ionenimplantation in ihrer Qualität beeinträchtigt wird.

Aus der Druckschrift C.H. Yun, N.W. Cheung: Thermal and Mechanical Separation of Silicon Layers from Hydrogen Pattern-Implanted Wafers, Journ. of Electronic Materials, Vol. 30, Nr. 8, 2001, S. 960-964, ist ein Verfahren zum thermischen oder mechanischen Abtrennen einer Siliziumschicht von einem Siliziumwafer bekannt.

In der Druckschrift US 6,225,193 B1 wird ein Verfahren zum Zertrennen eines Halbleiterwafers mittels Ionenimplantation offenbart.

Der Erfindung liegt die Aufgabe zugrunde, ein verbessertes Verfahren zum lateralen Zertrennen eines Halbleiterwafers anzugeben, bei dem die Gefahr einer Beschädigung der Halbleiterschichtenfolge bei der Ionenimplantation vermindert ist.

Diese Aufgabe wird durch ein Verfahren mit den Merkmalen des

Patentanspruchs 1 gelöst. Vorteilhafte Ausgestaltungen und Weiterbildungen der Erfindung sind Gegenstand der abhängigen Ansprüche 2-29.

Bei einem Verfahren zum lateralen Zertrennen eines Halbleiterwafers gemäß der Erfindung wird ein Aufwachssubstrat bereit gestellt, auf das eine Halbleiterschichtenfolge epitaktisch aufgewachsen wird, die eine funktionelle Halbleiterschicht umfasst. Durch Aufbringen einer Maskenschicht auf Teilbereiche der Halbleiterschichtenfolge werden maskierte und unmaskierte Bereiche erzeugt. Nachfolgend werden Ionen durch die unmaskierten Bereiche zur Erzeugung von Implantationsbereichen in den Halbleiterwafer implantiert.

Die Implantationsbereiche sind in einer als Trennschicht vorgesehenen Schicht der Halbleiterschichtenfolge angeordnet, wobei die Halbleiterschichtenfolge vor der Ionenimplantation derart strukturiert wird, dass sie Gräben aufweist, in denen die Trennschicht freigelegt ist. Das Aufwachssubstrat oder zumindest ein Teil des Aufwachssubstrats wird dann entlang der Implantationsbereiche von dem Halbleiterwafer abgetrennt.

Die Ionenimplantation in den Halbleiterwafer erfolgt also nicht ganzflächig, sondern vorteilhaft nur durch die nicht von der Maskenschicht bedeckten Bereiche der Halbleiterschichtenfolge. Die von der Maskenschicht bedeckten Teilbereiche der Halbleiterschichtenfolge, insbesondere die unterhalb der Maskenschicht angeordneten Bereiche der funktionellen Halbleiterschicht, werden auf diese Weise vor einer möglichen Schädigung bei dem Ionenimplantationsprozess geschützt.

Bei dem Verfahren wird die Halbleiterschichtenfolge vor der Ionenimplantation strukturiert. Beispielsweise kann die Halbleiterschichtenfolge derart strukturiert werden, dass sie eine zur Herstellung von Lumineszenzdioden oder Halbleiterlaserbauelementen geeignete Struktur aufweist.

Insbesondere kann die Halbleiterschichtenfolge derart strukturiert werden, dass der Halbleiterwafer eine oder vorzugsweise mehrere Streifenlaserstrukturen umfasst, die in einem nachfolgenden Prozessschritt in einzelne Streifenlaserbauelemente vereinzelt werden. Die Streifenlaser weisen bevorzugt eine Streifenbreite von etwa 1,5 µm bis etwa 3 µm auf. Eine derartige Breite der Strukturen ist vorteilhaft gering genug, dass die implantierten Ionen bei der Temperaturbehandlung weit genug in lateraler Richtung diffundieren, dass durch die Bläschenbildung eine vollständige Ablösung dieser Strukturen bewirkt wird.

Da die Strukturierung der Halbleiterschichtenfolge bereits vor der Ionenimplantation erfolgt, ist es vorteilhaft, wenn die erzeugte Struktur, insbesondere die Seitenflanken der Struktur, durch eine umhüllende Maskenschicht vor den Ionen geschützt werden. Unter einer umhüllenden Maskenschicht ist eine Maskenschicht zu verstehen, die sowohl die Oberfläche als auch die Seitenflanken der Struktur bedeckt.

Das Verfahren gemäß der Erfindung ist insbesondere zur Herstellung optoelektronischer Bauelemente, zum Beispiel zur Herstellung von Lumineszenzdioden oder Laserdioden, geeignet.

Bevorzugt werden bei der Ionenimplantation Wasserstoffionen implantiert. Alternativ können auch Ionen von Edelgasen wie beispielsweise Helium, Neon, Krypton oder Xenon verwendet werden.

Es ist auch möglich, dass Ionen verschiedener Atome implantiert werden, insbesondere Wasserstoffionen und Heliumionen oder Wasserstoffionen und Borionen. Dies hat den Vorteil, dass die benötigte Implantationsdosis verringert wird.

Das Zertrennen erfolgt vorzugsweise mittels einer Temperaturbehandlung, bevorzugt bei einer Temperatur im Bereich von 300 °C bis 1200 °C. Insbesondere kann die Temperaturbehandlung bei einer Temperatur zwischen 300 °C und 900 °C erfolgen. Dabei diffundieren die in die Implantationsbereiche implantierten Ionen und erzeugen dabei Bläschen (Blister). Beim Zusammenlaufen der Bläschen wird der Halbleiterwafer schließlich vollständig in lateraler Richtung zertrennt und auf diese Weise das Aufwachssubstrat oder zumindest ein Teil des Aufwachssubstrats von dem Halbleiterwafer abgetrennt.

Bei der Temperaturbehandlung kann das Aufheizen der Implantationsbereiche sowohl durch eine Erhöhung der Umgebungstemperatur als auch durch eine lokale Erwärmung durch elektromagnetische Strahlung, zum Beispiel Laser- oder Mikrowellenstrahlung, bewirkt werden.

Der Halbleiterwafer kann entlang der Implantationsbereiche vollständig in lateraler Richtung zertrennt werden, obwohl die Ionenimplantation aufgrund der Maskierung der Halbleiterschichtenfolge nur in Teilbereiche des Halbleiterwafers erfolgt. Dies beruht darauf, dass die Ionen bei der auf die Ionenimplantation folgenden Temperaturbehandlung in lateraler Richtung diffundieren und auf diese Weise ausgehend von den Implantationsbereichen auch die unterhalb der Maskenschicht angeordneten Teilbereiche des Halbleiterwafers mit Bläschen durchsetzen.

Alternativ kann der Halbleiterwafer entlang der Implantationsbereiche auch auf mechanische Weise zertrennt werden, beispielsweise indem die gegenüberliegen Oberflächen des Halbleiterwafers mit Hilfsträgern verbunden werden und auf diese ein Drehmoment ausgeübt wird, so dass der Halbleiterwafer entlang der Implantationsbereiche zertrennt wird.

Die Halbleiterschichtenfolge basiert vorzugsweise auf einem Nitridverbindungshalbleitermaterial. "Auf einem Nitridverbindungshalbleitermaterial basierend" bedeutet im folgenden, dass ein derart bezeichnetes Bauelement oder Teil eines Bauelements vorzugsweise InₓAl_{y}Ga_{1-x-y}N umfasst, wobei 0 ≤ x ≤ 1, 0 ≤ y ≤ 1 und x+y ≤ 1 gilt. Dabei muss dieses Material nicht zwingend eine mathematisch exakte Zusammensetzung nach obiger Formel aufweisen. Vielmehr kann es einen oder mehrere Dotierstoffe sowie zusätzliche Bestandteile aufweisen, die die physikalischen Eigenschaften des Materials im Wesentlichen nicht ändern. Der Einfachheit halber beinhaltet obige Formel jedoch nur die wesentlichen Bestandteile des Kristallgitters (Al, Ga, In, N), auch wenn diese teilweise durch geringe Mengen weiterer Stoffe ersetzt sein können.

Die funktionelle Halbleiterschicht ist vorzugsweise eine strahlungsemittierende oder strahlungsdetektierende Schicht. Insbesondere kann die funktionelle Halbleiterschicht die aktive Schicht einer Lumineszenzdiode oder eines Halbleiterlasers sein. Besonders bevorzugt weist die funktionelle Halbleiterschicht InₓAl_{y}Ga_{1-x-y}N mit 0 < x ≤ 1, 0 < y ≤ 1 und x + y ≤ 1 auf.

Das Aufwachsubstrat ist vorzugsweise ein zum epitaktischen Aufwachsen eines Nitridverbindungshalbleiters geeignetes Substrat, insbesondere ein GaN-Substrat, ein AlN-Substrat, ein SiC-Substrat oder ein Saphir-Substrat.

Alternativ kann die Halbleiterschichtenfolge auch auf einem Phosphidverbindungshalbleiter oder einem Arsenidverbindungshalbleiter basieren. In diesem Fall weist die Halbleiterschichtenfolge und insbesondere die funktionelle Halbleiterschicht bevorzugt InₓAl_{y}Ga_{1-x-y}P oder InₓAl_{y}Ga_{1-x-y}As mit 0 ≤ x ≤ 1, 0 ≤ y ≤ 1 und x + y ≤ 1 auf. Die Maskenschicht kann zum Beispiel aus Silizium, einem Metall, einem Dielektrikum wie zum Beispiel SiN oder SiO₂, oder einem Lack bestehen. Die Maskenschicht weist eine derartige Dicke auf, dass sie von den implantierten Ionen im Wesentlichen nicht durchdrungen werden kann. Beispielsweise kann die Maskenschicht eine polykristalline Siliziumschicht mit einer Dicke von 2 µm oder mehr sein.

Die maskierten Bereiche der Halbleiterschichtenfolge weisen vorzugsweise in zumindest einer lateralen Richtung eine Abmessung von 20 µm oder weniger, besonders bevorzugt von 5 µm oder weniger, auf. Eine derart geringe laterale Abmessung der maskierten Bereiche ist vorteilhaft, da angestrebt wird, dass die implantierten Ionen bei der Temperaturbehandlung aus den unterhalb der unmaskierten Bereiche der Halbleiterschicht liegenden Implantationsbereichen in die in lateraler Richtung angrenzenden Bereiche, die unterhalb der maskierten Bereiche der Halbleiterschichtenfolge liegen, diffundieren und so den Halbleiterwafer in lateraler Richtung vollständig mit Bläschen durchsetzen. Die Maskenschicht kann zum Beispiel eine streifenförmige Maskenschicht sein, bei der die Streifen eine Breite von 5 µm oder weniger, bevorzugt zwischen einschließlich 1,5 µm und 3 µm, aufweisen.

Die Implantationsbereiche werden zum Beispiel in dem Aufwachssubstrat erzeugt. In diesem Fall werden die Ionen durch die unmaskierten Bereiche des Halbleiterwafers in das Aufwachssubstrat implantiert.

Gemäß der vorliegenden Erfindung enthält die auf das Aufwachssubstrat aufgewachsene Halbleiterschichtenfolge eine als Trennschicht vorgesehene Schicht, in der die Implantationsbereiche erzeugt werden. Gemäß der Erfindung erfolgt die Ionenimplantation nicht in das Aufwachssubstrat, sondern in die Trennschicht. Dies hat den Vorteil, dass beim Zertrennen des Halbleiterwafers entlang der in der Trennschicht erzeugten Implantationsbereiche ein Teil des Halbleiterwafers abgetrennt wird, der das gesamte Aufwachssubstrat enthält. Das Aufwachssubstrat wird beim Zertrennen des Halbleiterwafers also vorteilhaft nicht durchtrennt und kann vollständig wieder verwendet werden. Insbesondere kann mehrfach eine Schichtenfolge auf dem Aufwachssubstrat aufgewachsen und nachfolgend abgetrennt werden, ohne dass dabei das Aufwachssubstrat sukzessiv verbraucht wird. Dies ist insbesondere dann vorteilhaft, wenn ein hochwertiges Substrat als Aufwachssubstrat verwendet wird, wie zum Beispiel ein GaN-Substrat, ein AlN-Substrat, ein SiC-Substrat oder ein Saphirsubstrat.

Nach dem Verfahrensschritt der Temperaturbehandlung zum Abtrennen des Aufwachsubstrats kann das Aufwachssubstrat einen abgetrennten Teil der Trennschicht enthalten. Dieser nach dem Abtrennen auf dem Aufwachssubstrat enthaltene Teil der Trennschicht wird vorzugsweise nachträglich vom Aufwachssubstrat entfernt, beispielsweise mittels eines Ätz- oder Polierprozesses, um das Aufwachssubstrat für das epitaktische Aufwachsen weiterer Halbleiterschichtenfolgen vorzubereiten.

Die Trennschicht enthält vorzugsweise zumindest ein Element, das eine größere Kernladungszahl als Gallium aufweist, zum Beispiel Indium. Das Element mit der größeren Kernladungszahl als Gallium kann als Dotierstoff in die Trennschicht eingebracht sein oder vorzugsweise Bestandteil des Halbleitermaterials der Trennschicht sein. Insbesondere kann die Trennschicht eine InGaN-Schicht sein. Das Vorhandensein eines Elements mit hoher Kernladungszahl in der Trennschicht hat den Vorteil, dass die bei der Ionenimplantation in die Trennschicht eindringenden Ionen abgebremst werden und somit ein weiteres Eindringen vermindert wird. Die Trennschicht wirkt in diesem Fall also als Stoppschicht für die implantierten Ionen.

Dies ist insbesondere dann vorteilhaft, wenn bei der Ionenimplantation vergleichsweise hochenergetische Ionen implantiert werden, um eine mögliche Schädigung der funktionellen Halbleiterschicht zu vermindern. Insbesondere hat sich herausgestellt, dass eine Schädigung der funktionellen Halbleiterschicht durch eine Erhöhung der Ionenenergie bei der Ionenimplantation vermindert werden kann. Eine Erhöhung der Ionenenergie hat allerdings in der Regel zur Folge, dass die implantierten Ionen ein breiteres und flacheres Konzentrationsprofil in einer Richtung senkrecht zur Ebene der Trennschicht ausbilden, das sich nachteilig auf den Ablöseprozess auswirken könnte. Die volle Halbwertsbreite des Konzentrationsprofils der implantierten Ionen kann beispielsweise etwa 200 nm betragen.

Dadurch, dass die Trennschicht mindestens ein Element mit einer Kernladungszahl, die größer ist als die von Gallium, enthält, kann auch bei vergleichsweise hoher Ionenenergie der implantierten Ionen ein vergleichsweise schmales Konzentrationsprofil in der Trennschicht erzielt werden, wodurch der Verfahrensschritt des Abtrennens erleichtert wird.

Bei einer weiteren vorteilhaften Ausgestaltung der Erfindung enthält die Halbleiterschichtenfolge mindestens eine der Trennschicht benachbarte Diffusionsbarriereschicht für die implantierten Ionen. Unter einer Diffusionsbarriereschicht wird dabei eine Schicht verstanden, in der die implantierten Ionen einen geringeren Diffusionskoeffizienten aufweisen als in der Trennschicht. Die Diffusionsbarriereschicht kann in der Wachstumsrichtung der Halbleiterschichtenfolge oberhalb und/oder unterhalb der Trennschicht angeordnet sein.

Die Diffusionsbarriereschicht enthält vorteilhaft ein mit Zn, Fe oder Si dotiertes Nitridverbindungshalbleitermaterial und ist bevorzugt nicht p-dotiert. Insbesondere hat sich herausgestellt, dass Wasserstoff in vergleichsweise hochohmigem Zn-dotierten GaN oder mit Si dotiertem n-GaN einen geringeren Diffusionskoeffizienten aufweist als in mit Mg dotiertem p-GaN.

Besonders bevorzugt ist beidseits der Trennschicht, also in Wachstumsrichtung der Halbleiterschichtenfolge sowohl oberhalb als auch unterhalb der Trennschicht, eine Diffusionsbarriereschicht angeordnet. Durch die Diffusionsbarriereschicht oder die Diffusionsbarriereschichten wird eine Diffusion der implantierten Ionen in einer senkrecht zur Ebene der Trennschicht verlaufenden Richtung vermindert. Auf diese Weise wird einer unerwünschten Verbreiterung des Konzentrationsprofils der implantierten Ionen in einer Richtung senkrecht zur Schichtebene der Trennschicht entgegen gewirkt. Insbesondere mit einer in Wachstumsrichtung der Schichtenfolge gesehen oberhalb der Trennschicht angeordneten Diffusionsbarriereschicht kann eine Diffusion der implantierten Ionen in die funktionelle Halbleiterschicht vermindert werden. Andernfalls könnte eine Diffusion der implantierten Ionen die Qualität der funktionellen Halbleiterschicht beeinträchtigen.

Bei einer weiteren bevorzugten Ausführungsform der Erfindung ist die Trennschicht eine tensil verspannte Schicht. Die Gitterkonstante der Trennschicht ist in diesem Fall geringer als die Gitterkonstante zumindest einer an die Trennschicht angrenzenden Schicht. Dies hat zur Folge, dass die Trennschicht einer Zugspannung ausgesetzt ist. Bevorzugt ist die tensil verspannte Schicht eine
Nitridverbindungshalbleiterschicht, die Aluminium enthält. Die tensile Verspannung der Trennschicht kann in diesem Fall beispielsweise dadurch hervorgerufen sein, dass an die Trennschicht eine weitere Nitridverbindungshalbleiterschicht angrenzt, die einen geringeren Aluminiumanteil als die Trennschicht aufweist oder sogar frei von Aluminium ist. Insbesondere kann eine InGaN-Schicht an die Trennschicht angrenzen. Eine tensile Verspannung der Trennschicht kann weiterhin dadurch erzeugt werden, dass die Trennschicht mit Silizium dotiert ist. Durch die tensile Verspannung der Trennschicht wird der Verfahrensschritt des Abtrennens vorteilhaft erleichtert, da die Grenzfläche zwischen der tensil verspannten Trennschicht und der angrenzenden Schicht mit größerer Gitterkonstante in diesem Fall als Sollbruchstelle wirkt.

Weiterhin kann bei der Erfindung der Verfahrensschritt des Abtrennens mit Vorteil dadurch erleichtert werden, dass die Trennschicht eine durch laterales epitaktisches Überwachsen (ELOG, Epitaxial Lateral Over Growth) hergestellte Halbleiterschicht ist. In diesem Fall wird die Trennschicht nicht direkt auf dem Aufwachssubstrat oder auf eine bereits auf das Aufwachssubstrat aufgebrachte Halbleiterschicht aufgewachsen, sondern vorher eine Maskenschicht auf das Aufwachssubstrat oder die Halbleiterschicht, auf der die Trennschicht aufgewachsen werden soll, aufgebracht. Diese Maskenschicht wird im Folgenden zur Unterscheidung von der für die Ionenimplantation verwendeten Maskenschicht als ELOG-Maskenschicht bezeichnet. Die ELOG-Maskenschicht ist vorzugsweise eine Siliziumnitridschicht oder eine Siliziumdioxidschicht.

Das epitaktische Wachstum der Trennschicht setzt in den nicht von der ELOG-Maskenschicht bedeckten Bereichen des Aufwachssubstrats ("Post"-Bereiche) oder der zum Aufwachsen vorgesehenen Halbleiterschicht ein, wobei nachfolgend die maskierten Bereiche ("Wing"-Bereiche) in lateraler Richtung überwachsen werden. Da die Haftung einer durch laterales epitaktisches Überwachsen hergestellten Trennschicht auf der lateral überwachsenen ELOG-Maskenschicht nur gering ist, wirken die Grenzflächen zwischen der Maskenschicht und der Trennschicht als Sollbruchstellen bei dem Verfahrensschritt des Abtrennens.

Bei der Ausführung der Trennschicht als ELOG-Schicht erfolgt die Ionenimplantation vorzugsweise in die Bereiche der Trennschicht, die von der ELOG-Maskenschicht in lateraler Richtung versetzt angeordnet sind ("Post"-Bereiche). Dazu weisen die für die Ionenimplantation verwendete Maskenschicht und ELOG-Maskenschicht vorteilhaft die gleiche Strukturierung auf. Dies ist so zu verstehen, dass in vertikaler Richtung gesehen die von der Maskenschicht maskierten Bereiche der Halbleiterschicht den von der ELOG-Maskenschicht maskierten Bereichen des Aufwachssubstrats gegenüber liegen und bevorzugt deckungsgleich sind. Auf eine Ionenimplantation in die oberhalb der ELOG-Maskenschicht angeordneten Bereiche der Trennschicht ("Wing"-Bereiche) kann vorteilhaft verzichtet werden, da die Trennschicht in diesen Bereichen aufgrund der geringen Haftung der Trennschicht auf der ELOG-Maskenschicht vergleichsweise einfach durchtrennt werden kann.

Weiterhin ist es vorteilhaft, wenn die Trennschicht aus einem Halbleitermaterial gebildet ist, in dem die implantierten Ionen einen größeren Diffusionskoeffizienten als in einer an die Trennschicht angrenzenden Schicht aufweisen. Dadurch wird die Diffusion der implantierten Ionen innerhalb der Trennschicht, also insbesondere in einer parallel zur Ebene des Halbleiterwafers verlaufenden Richtung, erhöht und somit das Ausbilden von Bläschen in der Trennschicht gefördert, wodurch der Verfahrensschritt des Abtrennens erleichtert wird. Die diffusionsfördernde Trennschicht ist vorzugsweise eine p-dotierte Nitridverbindungshalbleiterschicht, die zum Beispiel mit Mg dotiert sein kann. Insbesondere hat sich herausgestellt, dass Wasserstoff in p-dotiertem GaN einen höheren Diffusionskoeffizienten aufweist als in einer mit Zn dotierten hochohmigen GaN-Schicht oder einer mit Silizium dotierten n-GaN-Schicht.

Der Halbleiterwafer wird vorzugsweise vor dem Zertrennen an einer von dem Aufwachssubstrat abgewandten Oberfläche mit einem Trägersubstrat verbunden. Das Trägersubstrat stabilisiert die Halbleiterschichtenfolge nach dem Abtrennen von dem Aufwachssubstrat und kann insbesondere als Träger für ein aus der Halbleiterschichtenfolge hergestelltes optoelektronisches Bauelement fungieren.

Das Trägersubstrat kann ein Zwischenträger sein, wobei ein Abtrennen oder Auflösen des Zwischenträgers in einem nachfolgenden Verfahrensschritt vorgesehen ist. Beispielsweise ist der Zwischenträger ein Glassubstrat. Das Glassubstrat wird vorzugsweise mittels einer Zwischenschicht aus einem Siliziumoxid mit der Halbleiterschichtenfolge verbunden. Der Zwischenträger kann in diesem Fall in einem späteren Verfahrensschritt einschließlich der Zwischenschicht zum Beispiel in Flusssäure (HF) aufgelöst werden.

Die bei der Ionenimplantation verwendete Maskenschicht kann beispielsweise vor dem Verbinden der Halbleiterschichtenfolge mit dem Trägersubstrat entfernt werden. Alternativ kann die Maskenschicht auch auf der Halbleiterschichtenfolge verbleiben, wobei vorzugsweise vor dem Verbinden der Halbleiterschichtenfolge mit dem Trägersubstrat eine Zwischenschicht aufgebracht wird, welche die Maskenschicht planarisiert. Die planarisierende Zwischenschicht hat den Vorteil, dass die Gewichtskraft des Trägersubstrats auch auf die unmaskierten Bereiche der Halbleiterschichtenfolge wirkt, die ansonsten durch die Maskenschicht von dem Trägersubstrat beabstandet wären. Die Einwirkung der Gewichtskraft des Trägersubstrats auf die Implantationsbereiche hat bei dem Verfahrensschritt der Temperaturbehandlung den Vorteil, dass eine Ausbreitung der durch die Diffusion der Ionen erzeugten Bläschen in lateraler Richtung gefördert und in einer senkrecht zur Wachstumsrichtung der Halbleiterschichtenfolge verlaufenden vertikalen Richtung vermindert wird.

Im Fall einer Maskenschicht aus einem Metall oder einer Metalllegierung kann diese als elektrische Kontaktschicht auf der Halbleiterschichtenfolge verbleiben. In diesem Fall ist die elektrische Kontaktschicht ohne weiteren Herstellungsaufwand strukturiert auf die Bereiche der Halbleiterschichtenfolge aufgebracht, in die keine Ionen implantiert werden. Gegebenenfalls kann ein zur Ausbildung eines elektrischen Kontakts mit der obersten Schicht der Halbleiterschichtenfolge geeignetes Kontaktmetall in die Maskenschicht eingebracht werden. Vorteilhaft wird bei der Temperaturbehandlung zur Erzeugung der Bläschen gleichzeitig ein Kontaktmetall durch Ausbilden einer Legierung mit dem Metall der Maskenschicht in die Maskenschicht eingebracht.

Bei einer besonders bevorzugten Ausführungsform wird vor dem Verbinden des Halbleiterwafers mit dem Trägersubstrat eine Zwischenschicht auf die unmaskierten Bereiche des Halbleiterwafers aufgebracht, deren Dicke größer als die Dicke der Maskenschicht ist. In diesem Fall sind die maskierten Bereiche der Halbleiterschichtenfolge durch die auf die unmaskierten Bereiche aufgebrachte Zwischenschicht von dem Trägersubstrat beabstandet. Deshalb wirkt die Gewichtskraft des Trägersubstrats vorteilhaft in erster Linie auf die unmaskierten Bereiche ein, wodurch die Ausbreitung der durch die Diffusion der implantierten Ionen erzeugten Bläschen in lateraler Richtung verstärkt und in vertikaler Richtung gehemmt wird. Die Ausbreitung der erzeugten Bläschen in die unterhalb der Maskenschicht angeordneten Bereiche des Halbleiterwafers wird auf diese Weise gefördert. Dieser Effekt kann alternativ auch dadurch erzielt werden, dass die Maskenschicht entfernt wird und eine Zwischenschicht auf die Halbleiterschichtenfolge aufgebracht wird, die derart strukturiert ist, dass sie im wesentlichen die Bereiche der Halbleiterschichtenfolge bedeckt, in welche die Ionen implantiert wurden. Die Wirkung der Gewichtskraft des Trägersubstrats auf die Implantationsbereiche kann durch die Ausübung einer zum Aufwachssubstrat hin gerichteten Kraft auf das Trägersubstrat verstärkt werden.

Die Erfindung wird im Folgenden anhand des Ausführungsbeispiels der Figur 4 und weiteren Beispielen, die nicht oder zumindest nicht explizit alle Merkmale der Erfindung aufweisen, im Zusammenhang mit den Figuren 1 bis 13 näher erläutert.

Es zeigen:
Figuren 1A, 1B, 1C, 1D, 1E, 1F und 1G schematische Darstellungen eines Querschnitts durch einen Halbleiterwafer bei Zwischenschritten eines Beispiels eines Verfahrens,
Figur 2 eine schematische Darstellung eines Querschnitts durch einen Halbleiterwafer vor dem Verfahrensschritt des Zertrennens des Halbleiterwafers bei einem weiteren Beispiel eines Verfahrens,
Figur 3 eine schematische Darstellung eines Querschnitts durch einen Halbleiterwafer vor dem Verfahrensschritt des Zertrennens des Halbleiterwafers bei einem weiteren Beispiel eines Verfahrens,
Figur 4 eine schematische Darstellung eines Querschnitts durch einen Halbleiterwafer bei dem Verfahrensschritt der Ionenimplantation bei einem Ausführungsbeispiel eines Verfahrens gemäß der Erfindung,
Figur 5 eine schematische Darstellung eines Querschnitts durch einen Halbleiterwafer bei dem Verfahrensschritt der Ionenimplantation bei einem weiteren Beispiel eines Verfahrens ,
Figur 6A eine schematische Darstellung eines Querschnitts durch einen Halbleiterwafer bei dem Verfahrensschritt der Ionenimplantation bei einem weiteren Beispiel eines Verfahrens,
Figur 6B eine schematische Darstellung eines Querschnitts durch den ein Fig. 6A dargestellten Halbleiterwafer nach der Strukturierung der Halbeleiterschichtenfolge zu einem Laserstreifen,
Figur 7 eine schematische Darstellung eines Querschnitts durch einen Halbleiterwafer bei dem Verfahrensschritt der Ionenimplantation bei einem weiteren Beispiel eines Verfahrens,
Figur 8 eine schematische Darstellung eines Querschnitts durch einen Halbleiterwafer bei dem Verfahrensschritt der Ionenimplantation bei einem weiteren Beispiel eines Verfahrens,
Figur 9 eine schematische Darstellung eines Querschnitts durch einen Halbleiterwafer bei dem Verfahrensschritt der Ionenimplantation bei einem weiteren Beispiel eines Verfahrens,
Figur 10 eine schematische Darstellung eines Querschnitts durch einen Halbleiterwafer bei dem Verfahrensschritt der Ionenimplantation bei einem weiteren Beispiel eines Verfahrens,
Figuren 11 bis 13B schematische Darstellungen einer Aufsicht auf die Maskenschicht bei weiteren Beispielen eines Verfahrens.

Gleiche oder gleich wirkende Elemente sind in den Figuren mit den gleichen Bezugszeichen versehen. Die dargestellten Elemente sind nicht als maßstabsgerecht anzusehen, vielmehr können einzelne Elemente zum besseren Verständnis übertrieben groß dargestellt sein.

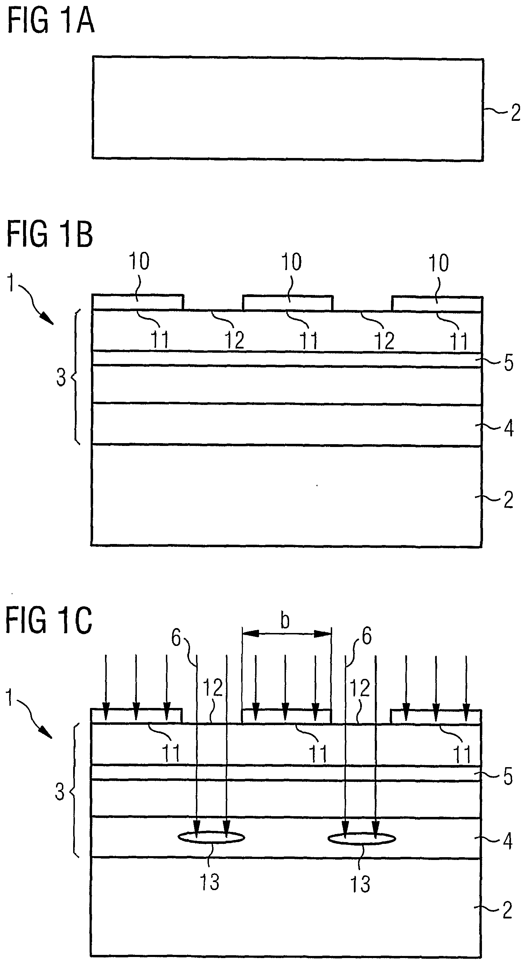

Wie in Figur 1A dargestellt, wird bei einem Verfahren ein Aufwachssubstrat 2 bereitgestellt. Das Aufwachssubstrat 2 ist ein zum epitaktischen Aufwachsen eines Nitridverbindungshalbleiters geeignetes Substrat, das bevorzugt ein GaN-Substrat, ein AlN-Substrat oder alternativ ein SiC-Substrat oder ein Saphir-Substrat ist.

Bei dem in Figur 1B schematisch dargestellten Zwischenschritt ist eine Halbleiterschichtenfolge 3 epitaktisch auf das Aufwachssubstrat 2 aufgewachsen. Der auf diese Weise hergestellte Halbleiterwafer 1 enthält das Aufwachssubstrat 2 und die Halbleiterschichtenfolge 3. Die Halbleiterschichtenfolge 3 ist beispielsweise mittels metallorganischer Gasphasenepitaxie (MOVPE) auf das Aufwachssubstrat 2 aufgebracht.

Die epitaktische Halbleiterschichtenfolge 3 basiert vorzugsweise auf einem Nitridverbindungshalbleiter. Die epitaktische Halbleiterschichtenfolge 3 enthält mindestens eine funktionelle Halbleiterschicht 5, zum Beispiel eine für ein optoelektronisches Bauelement vorgesehene strahlungsemittierende oder strahlungsdetektierende Schicht.

Insbesondere kann es sich bei der funktionellen Halbleiterschicht 5 um eine aktive Schicht einer Lumineszenzdiode oder eines Halbleiterlasers handeln. Die aktive Schicht kann dabei zum Beispiel als Heterostruktur, Doppelheterostruktur oder als Quantentopfstruktur ausgebildet sein. Die Bezeichnung Quantentopfstruktur umfasst dabei jegliche Struktur, bei der Ladungsträger durch Einschluss (Confinement) eine Quantisierung ihrer Energiezustände erfahren. Insbesondere beinhaltet die Bezeichnung Quantentopfstruktur keine Angabe über die Dimensionalität der Quantisierung. Sie umfasst somit unter anderem Quantentröge, Quantendrähte und Quantenpunkte und jede Kombination dieser Strukturen.

Weiterhin ist bei dem in Figur 1B dargestellten Zwischenschritt eine strukturierte Maskenschicht 10 auf die Halbeliterschichtenfolge 3 aufgebracht. Die Oberfläche der Halbleiterschichtenfolge 3 weist also von der Maskenschicht 10 bedeckte maskierte Bereiche 11 und unmaskierte Bereiche 12 auf. Es ist vorteilhaft, wenn die Breite b der maskierten Bereiche 11 in zumindest einer lateralen Richtung 20 µm oder weniger, besonders bevorzugt 5 µm oder weniger, beträgt.

Bei dem in Fig. 1C schematisch dargestellten Zwischenschritt werden, wie durch die Pfeile 6 angedeutet, Ionen durch die unmaskierten Bereiche 12 durch die Halbleiterschichtenfolge 3 hindurch zur Erzeugung von Implantationsbereichen 13 in den Halbleiterwafer 1 implantiert.

In die maskierten Bereiche 11 der Halbleiterschichtenfolge 3 können die Ionen dagegen vorteilhaft nicht eindringen, da sie das Material der Maskenschicht 10 im Wesentlichen nicht durchdringen können. Insbesondere wird auf diese Weise verhindert, dass die unterhalb der maskierten Bereiche 11 angeordneten Teilbereiche der funktionellen Halbleiterschicht 5 bei dem Verfahrensschritt der Ionenimplantation beschädigt werden.

Die Maskenschicht 10 kann zum Beispiel aus einem Metall, einem Dielektrikum oder einem Lack gebildet sein, wobei die Dicke in Abhängigkeit von der Ionenenergie der implantierten Ionen derart gewählt ist, dass die Maskenschicht 10 von den Ionen im Wesentlichen nicht durchdrungen werden kann. Zum Beispiel kann die Maskenschicht 10 eine etwa 2 µm dicke Siliziumoxidschicht sein.

Bei den implantierten Ionen kann es sich insbesondere um Wasserstoffionen, oder alternativ um Ionen von Edelgasen wie beispielsweise Helium, Neon, Krypton oder Xenon handeln.

Es ist auch möglich, dass Ionen verschiedener Atome implantiert werden, insbesondere Wasserstoffionen und Heliumionen oder Wasserstoffionen und Borionen. Dies hat den Vorteil, dass die benötigte Implantationsdosis verringert wird.

Die Implantationsbereiche 13 werden vorzugsweise in einer als Trennschicht vorgesehenen Schicht 4, die in der Halbleiterschichtenfolge 3 enthalten ist, erzeugt. Alternativ ist es auch möglich, die Ionen zur Ausbildung der Implantationsbereiche 13 in das Aufwachssubstrat 2 zu implantieren.

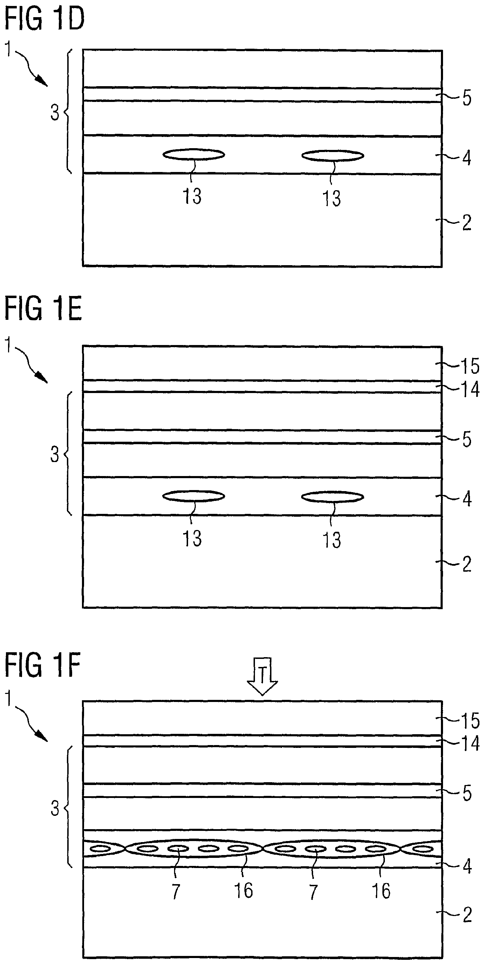

Die Maskenschicht 10 kann daraufhin, wie in Fig. 1D dargestellt, wieder von der Halbleiterschichtenfolge 3 entfernt werden.

Nachfolgend wird der Halbleiterwafer 1, wie in Fig. 1E dargestellt, an einer von dem Aufwachssubstrat 2 abgewandten Seite mit einem Trägersubstrat 15 verbunden. Da das Trägersubstrat 15 im Gegensatz zum Aufwachssubstrat 2 nicht zum epitaktischen Aufwachsen der Halbleiterschichtenfolge 3, die zum Beispiel auf einem
Nitridverbindungshalbleitermaterial basiert, geeignet sein muss, besteht für das Trägersubstrat 15 eine vergleichsweise große Freiheit bei der Materialauswahl. Insbesondere kann ein Trägersubstrat 15 ausgewählt werden, das sich durch vergleichsweise geringe Kosten und/oder eine gute Wärmeleitfähigkeit auszeichnet. Beispielsweise kann das Trägersubstrat 15 aus Ge, GaAs, Metallen wie beispielsweise Mo oder Au, Metalllegierungen oder Keramiken wie zum Beispiel AlN gebildet sein. Das Trägersubstrat 15 wird vorzugsweise mittels Löten oder Bonden mit der Halbleiterschichtenfolge 3 verbunden.

Vor dem Verbinden des Halbleiterwafers 1 mit dem Trägersubstrat 15 kann eine Zwischenschicht 14 auf die Halbleiterschichtenfolge 3 aufgebracht werden. Die Zwischenschicht 14 kann zum Beispiel zu dem Zweck aufgebracht werden, die Halbleiterschichtenfolge 3 nach dem Verfahrensschritt der Ionenimplantation und dem Entfernen der Maskenschicht zu glätten. Weiterhin kann die Zwischenschicht 14 auch eine reflektierende Schicht sein, die in einem optoelektronischen Bauelement ein Eindringen von Strahlung in das Trägersubstrat 15 verhindern soll.

Nachfolgend wird, wie in Figur 1F durch den Pfeil T angedeutet, eine Temperaturbehandlung durchgeführt, die eine Diffusion der in die Implantationsbereiche 13 implantierten Ionen bewirkt.

Die Temperaturbehandlung erfolgt vorzugsweise bei einer Temperatur zwischen 300 °C und 1200 °C. Die durch die Temperaturbehandlung angeregte Diffusion der implantierten Ionen führt zu einer Ausbildung von Bläschen 7, deren Größe und Anzahl mit zunehmender Dauer der Temperaturbehandlung zunimmt.

Auf diese Weise entstehen von Bläschen 7 durchsetzte Diffusionsbereiche 16, die sich in lateraler Richtung auch unter die zuvor maskierten Bereiche der
Halbleiterschichtenfolge 3 ausdehnen und dort schließlich zusammenlaufen.

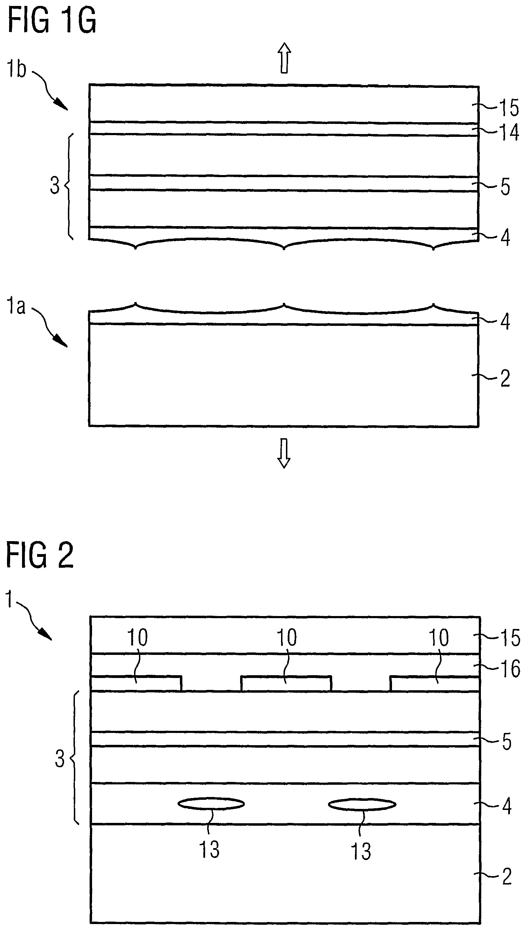

Das Zusammenlaufen der von Bläschen 7 durchsetzten Diffusionsbereiche 16 führt, wie in Figur 1G schematisch dargestellt ist, schließlich zu einem Zertrennen des Halbleiterwafers in zwei Teile 1a, 1b.

Der von dem Aufwachssubstrat 2 abgetrennte Teil 1b des Halbleiterwafers 1 kann insbesondere ein optoelektronisches Bauelement sein, beispielsweise eine Lumineszenzdiode oder ein Halbleiterlaser, oder zu einem optoelektronischen Bauelement weiterverarbeitet werden. Weiterhin kann der abgetrennte Teil 1b des Halbleiterwafers auch zu einer Mehrzahl optoelektronischer Bauelemente vereinzelt werden.

Dadurch, dass die Ionen nicht in das Aufwachssubstrat 2, sondern in eine als Trennschicht 4 vorgesehene Schicht der Halbleiterschichtenfolge 3 implantiert werden, wird beim Zertrennen des Halbleiterwafers 1 vorteilhaft ein Teil 1a des Halbleiterwafers 1 abgetrennt, der das gesamte Aufwachssubstrat 2 enthält. Der abgetrennte Teil 1a des Halbleiterwafers 1 enthält nach dem Zertrennen, wie schematisch in Figur 1G dargestellt ist, Reste der Trennschicht 4, die in einem nachträglichen Ätz- oder Polierprozess entfernt werden können. Das Aufwachssubstrat 2 ist also vollständig wieder verwertbar. Weiterhin kann auch die mit dem Trägersubstrat 15 verbundene Halbleiterschichtenfolge 3 Reste der Trennschicht 4 aufweisen, die vorteilhaft in einem nachträglichen Ätz- oder Polierprozess entfernt werden.

In Figur 2 ist ein Halbleiterwafer nach dem Verfahrensschritt der Ionenimplantation in die Implantationsbereiche 13 bei einem weiteren Beispiel dargestellt, wobei die Maskenschicht 10 nicht wie bei dem zuvor beschriebenen Beispiel von der Oberfläche der Halbleiterschichtenfolge 3 entfernt wurde, sondern vor dem Verbinden des Halbleiterwafers 1 mit dem Trägersubstrat 15 mit einer planarisierenden Zwischenschicht 16 versehen wurde. Die Maskenschicht 10 wird durch die Zwischenschicht 16 eingeebnet und wird vorteilhaft nicht vor dem Verbinden des Halbleiterwafers 1 mit dem Trägersubstrat 15 entfernt. Der Herstellungsaufwand wird auf diese Weise vermindert.

Das mit der planarisierenden Zwischenschicht 16 verbundene Trägersubstrat 15 übt beim nachfolgenden Verfahrensschritt der Temperaturbehandlung eine Kraft auf die Implantationsbereiche 13 aus, welche die laterale Ausbreitung der Bläschen fördert und die vertikale Ausbreitung vermindert.

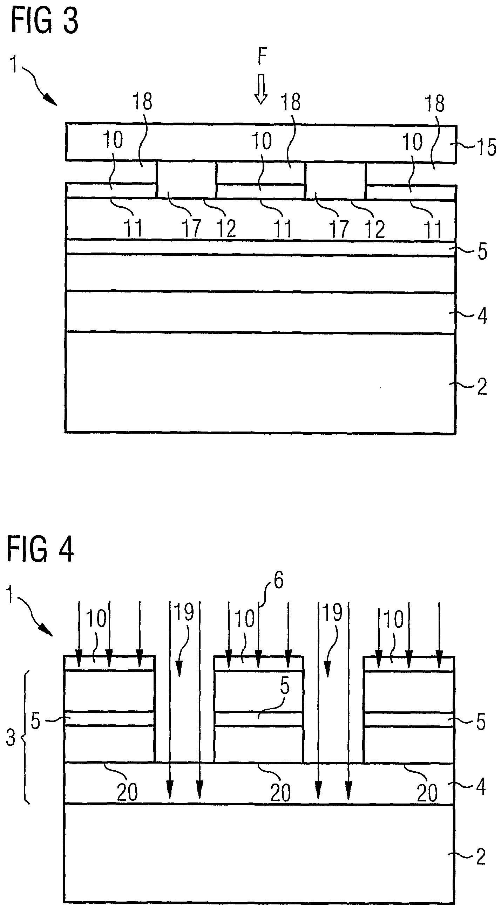

Dieser vorteilhafte Einfluss des Trägersubstrats 15 auf die Ausbreitung der bei der Temperaturbehandlung erzeugten Bläschen kann weiter verstärkt werden, wenn, wie in Figur 3 anhand eines weiteren Beispiels dargestellt, der Halbleiterwafer 1 über eine Zwischenschicht 17 mit dem Trägersubstrat 15 verbunden wird, die eine größere Dicke als die Maskenschicht 10 aufweist. In diesem Fall ist der Halbleiterwafer 1 nur in den unmaskierten Bereichen 12 über die Zwischenschicht 17 mit dem Trägersubstrat 15 verbunden, wohingegen die maskierten Bereiche 11 durch Zwischenräume 18 von dem Trägersubstrat 15 beabstandet sind. Um den Einfluss des Trägersubstrats 15 auf die Diffusion der in die Implantationsbereiche 13 implantierten Ionen weiter zu erhöhen, wird während des Verfahrensschritts der Temperaturbehandlung vorteilhaft eine Kraft F auf das Trägersubstrat 15 in Richtung zum Halbleiterwafer 1 hin ausgeübt.

In Figur 4 ist ein Halbleiterwafer 1 bei dem
Verfahrensschritt der Ionenimplantation bei einem Ausführungsbeispiel der Erfindung schematisch dargestellt, bei dem die Halbleiterschichtenfolge 3 vor der Ionenimplantation strukturiert wurde. Die Halbleiterschichtenfolge 3 ist derart strukturiert, dass sie Gräben 19 aufweist, in der die Trennschicht 4, beispielsweise mittels eines Ätzprozesses, freigelegt ist. Durch die in der Halbleiterschichtenfolge 3 erzeugten Gräben 19 können die Ionen bei der Ionenimplantation direkt in die Trennschicht 4 implantiert werden, ohne dabei die übrigen Schichten der Halbleiterschichtenfolge 3, insbesondere die funktionelle Halbleiterschicht 5, zu durchqueren. Dies hat insbesondere den Vorteil, dass bei der Ionenimplantation nur eine vergleichsweise geringe Ionenenergie und/oder Ionendosis erforderlich ist. Die zwischen den Gräben 19 angeordneten Teilbereiche 20 der Halbleiterschichtenfolge 3 können beispielsweise in einem späteren Verfahrensschritt in einzelne optoelektronische Bauelemente, beispielsweise zu Streifenlasern, vereinzelt werden. Weiterhin ist es auch möglich, dass eine Mehrzahl der durch Gräben 19 separierten Teilbereiche 20 gemeinsam den Halbleiterchip eines optoelektronischen Bauelementes, beispielsweise einer Lumineszenzdiode, ausbilden.

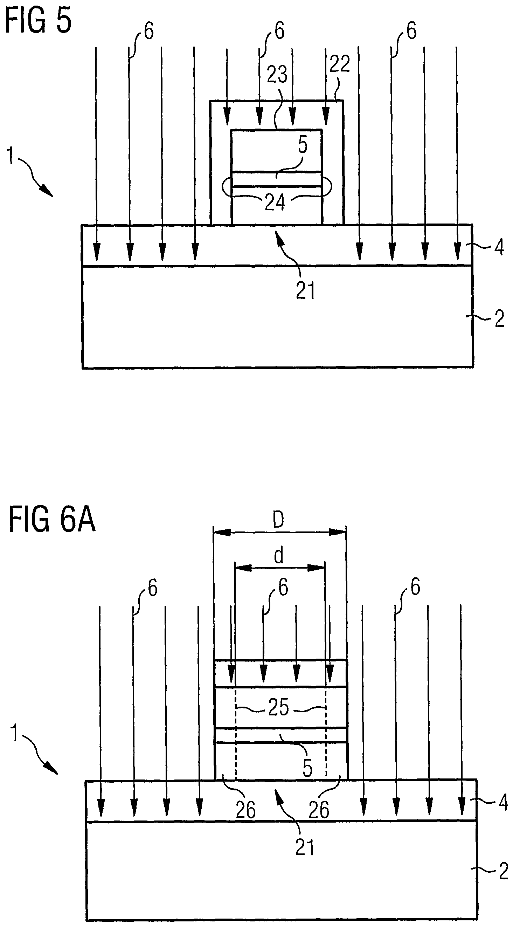

Bei dem in Figur 5 dargestellten Verfahrensschritt der Ionenimplantation bei einem Beispiel des Verfahrens ist eine Halbleiterschichtenfolge vor der Ionenimplantation zu einem Streifenlaser 21 strukturiert worden. Der Streifenlaser 21 ist vorteilhaft von einer umhüllenden Maskenschicht 22 umgeben, die nicht nur die Oberfläche 23, sondern auch die Seitenflanken 24 des Streifenlasers 21 abdeckt. Dies hat den Vorteil, dass die Seitenflanken 24 bei der Ionenimplantation gegen möglicherweise auftreffende hochenergetische Ionen geschützt sind. Insbesondere wird dadurch einer Schädigung der aktiven Zone 5 des Streifenlasers 21 vorgebeugt. Weiterhin ist es vorteilhaft, dass die an den Streifenlaser 21 angrenzenden Bereiche der Trennschicht 4 von der Maskenschicht 22 bedeckt sind, um beim Betrieb des Streifenlasers eine nichtstrahlende Rekombination der Ladungsträger in den ionenimplantierten Bereichen zu vermindern. Zum Beispiel kann die Maskenschicht 22 bei einem 1,5 µm breiten Streifenlaser 21 eine Breite von 5,5 µm aufweisen, so dass auf beiden Seiten des Streifenlasers 21 jeweils ein 2 µm breiter streifenförmiger Bereich der Oberfläche der Trennschicht 4 maskiert ist.

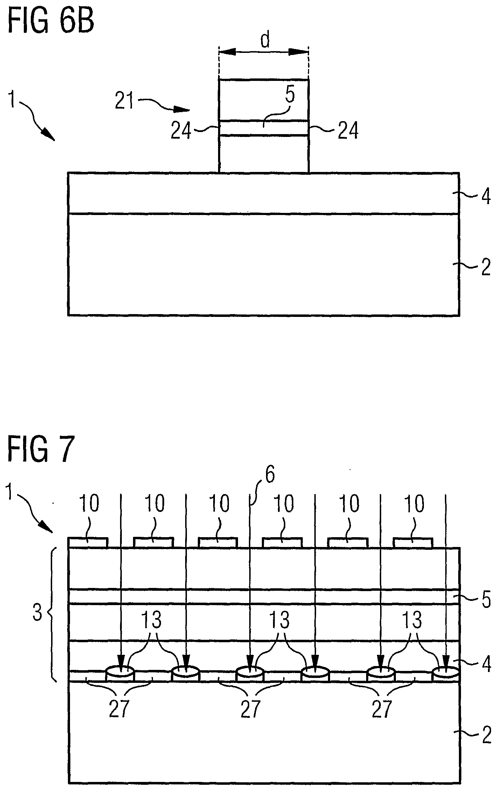

Ein weiteres Beispiel des Verfahrens, bei dem eine mögliche Schädigung der Seitenflanken 24 eines optoelektronischen Bauelements, insbesondere eines Streifenlasers 21, bei dem Verfahrensschritt der Ionenimplantation vermieden wird, ist in den Figuren 6A und 6B schematisch dargestellt.

Auf den in Figur 6A dargestellten Halbleiterwafer 1 ist eine Halbleiterschichtenfolge aufgebracht, die derart strukturiert ist, dass sie eine Breite D aufweist, die größer ist als eine Breite d, die für den in Figur 6B dargestellten Streifenlaser 21 vorgesehen ist. Die außerhalb der in Figur 6A dargestellten gestrichelten Linien 25 angeordneten Teilbereiche 26 der Halbleiterschichtenfolge werden erst nach dem Verfahrensschritt der Ionenimplantation durch einen weiteren Strukturierungsschritt entfernt, um den in Figur 6B dargestellten Streifenlaser 21 herzustellen. Auf diese Weise werden die Seitenflanken 24 des Streifenlasers 21 bei dem vorhergehenden Verfahrensschritt der Ionenimplantation vor einer möglichen Schädigung geschützt.

Bei dem in Figur 7 schematisch dargestellten Zwischenschritt der Ionenimplantation bei einem weiteren Beispiel des Verfahrens ist die Trennschicht 4 eine durch epitaktisches laterales Überwachsen (ELOG) hergestellte Schicht. Zur Herstellung der ELOG-Schicht wird eine Maskenschicht 27 strukturiert auf das Aufwachssubstrat 2 aufgebracht. Alternativ könnte, falls die Trennschicht 4 nicht direkt auf das Aufwachssubstrat 2 aufgebracht ist, die Maskenschicht 27 auf eine in Wachstumsrichtung unterhalb der Trennschicht 4 angeordnete Halbleiterschicht aufgebracht sein.

Bei der ELOG-Maskenschicht 27 kann es sich insbesondere um eine Siliziumnitrid- oder Siliziumoxidschicht handeln.

Anstelle einer ELOG-Maskenschicht 27 kann auch eine in-situ-SiN-Schicht zum Aufwachsen der Trennschicht mittels lateralen Überwachsens verwendet werden. Eine in-situ SiN-Schicht wird als derart dünne Schicht aufgebracht, dass sie noch nicht zu einer kontinuierlichen Schicht zusammengewachsen ist und somit das Aufwachssubstrat nicht vollständig bedeckt. Auf diese Weise fungiert die in-situ-SiN-Schicht als Maskenschicht.

Die mittels lateralem epitaktischen Überwachsen hergestellte Trennschicht 4 vereinfacht das Zertrennen des Halbleiterwafers 1, da das Halbleitermaterial der Trennschicht 4 auf den Bereichen der Maskenschicht 27, die lateral überwachsen werden, eine vergleichsweise geringe Haftung aufweist. Der Halbleiterwafer 1 kann daher in einer Ebene, die entlang einer der Trennschicht 4 zugewandten Oberfläche der Maskenschicht 27 verläuft, mit vergleichsweise geringem Aufwand zertrennt werden.

Besonders bevorzugt stimmen die Struktur der ELOG-Maskenschicht 27 und die Struktur der Maskenschicht 10, die für die Ionenimplantation verwendet wird, überein. In diesem Fall werden die Ionen vorteilhaft in Implantationsbereiche 13 der Trennschicht 4 implantiert, die zwischen den lateral von der Trennschicht 4 überwachsenen Bereichen der ELOG-Maskenschicht 27 angeordnet sind.

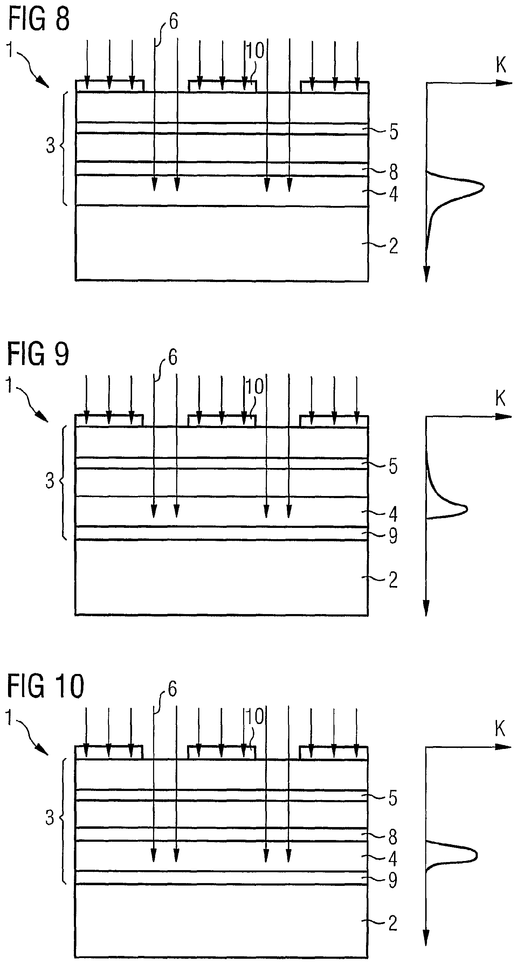

Bei einem weiteren bevorzugten Beispiel ist, wie in Figur 8 schematisch dargestellt, eine Diffusionsbarriereschicht 8 in Wachstumsrichtung der Halbleiterschichtenfolge 3 oberhalb der Trennschicht 4 angeordnet.

Die Diffusionsbarriereschicht 8 ist bevorzugt eine hochohmige oder n-dotierte Nitridverbindungshalbleiterschicht, zum Beispiel eine mit Zn dotierte GaN-Schicht oder eine Si-dotierte n-GaN-Schicht. Insbesondere ist die Diffusionsbarriereschicht 8 nicht p-dotiert.

Die Diffusionsbarriereschicht 8 vermindert vorteilhaft eine Diffusion der in die Trennschicht 4 implantierten Ionen in darüber liegende Halbleiterschichten, insbesondere in die funktionelle Halbleiterschicht 5. Das schematisch dargestellte Tiefenprofil der Konzentration K der implantierten Ionen wird auf diese Weise nach oben hin verschmälert. Einer Schädigung der funktionellen Halbleiterschicht durch diffundierende Ionen wird auf diese Weise vorgebeugt.

Bei dem in Figur 9 dargestellten Beispiel ist eine Diffusionsbarriereschicht 9 im Gegensatz zu dem in Figur 8 dargestellten Beispiel nicht oberhalb, sondern unterhalb der Trennschicht 4 angeordnet. Durch die in Wachstumsrichtung unterhalb der Trennschicht 4 angeordnete Diffusionsbarriereschicht 9 wird vorteilhaft eine Diffusion der implantierten Ionen in das Aufwachssubstrat 2 vermindert und das schematisch dargestellte Tiefenprofil der Konzentration K der implantierten Ionen zum Aufwachssubrat 2 hin verschmälert.

Besonders bevorzugt sind, wie in Figur 10 anhand eines weiteren Beispiels dargestellt, sowohl unterhalb als auch oberhalb der Trennschicht 4 Diffusionsbarriereschichten 8, 9 angeordnet. In diesem Fall wird das Konzentrationsprofil K der implantierten Ionen vorteilhaft auf beiden Seiten der Trennschicht 4 durch eine Verminderung der Diffusion der Ionen in die angrenzenden Schichten und das Aufwachssubstrat 2 verschmälert.

Selbstverständlich kann die anhand der Figuren 8 bis 10 erläuterte Anordnung von Diffusionsbarriereschichten 8, 9 oberhalb und/oder unterhalb der Trennschicht 4 mit den zuvor beschriebenen vorteilhaften Ausgestaltungen der Trennschicht 4 kombiniert werden.

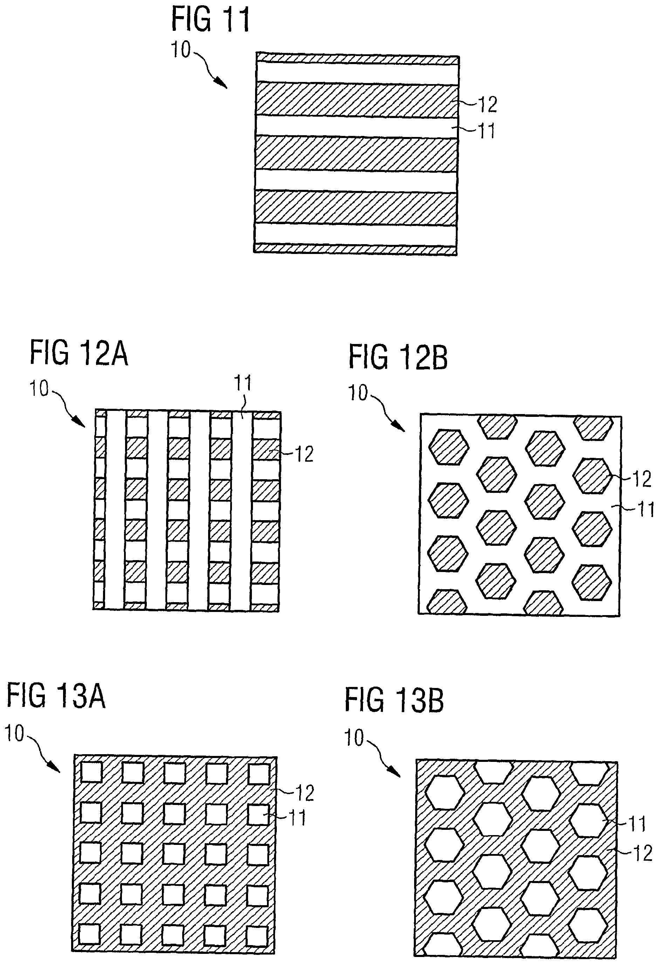

In den Figuren 11, 12 und 13 werden verschiedene Ausführungsformen der Maskenschicht 10 bei Beispielen des Verfahrens anhand von schematisch dargestellten Aufsichten auf den Halbleiterwafer nach dem Verfahrenschritt des Aufbringens der Maskenschicht gezeigt. Die unmaskierten Bereiche 12 sind dabei im Gegensatz zu den maskierten Bereichen 11 jeweils schraffiert dargestellt.

Das in Figur 11 dargestellte Beispiel zeigt eine streifenförmige Maskenschicht 10, die insbesondere bei einer Anwendung des erfindungsgemäßen Verfahrens zur Herstellung von optoelektronischen Bauelementen, wie insbesondere Streifenlasern, verwendet werden kann. Die Breite der Streifen beträgt vorzugsweise 5 µm oder weniger.

Alternativ kann die Maskenschicht 10, wie beispielsweise in den Figuren 12A und 12B dargestellt, auch eine Gitterstruktur aufweisen. Die Gitterstruktur kann beispielsweise ein in Figur 12A dargestelltes Streifengitter sein. Alternativ sind auch beliebige andere Gitterstrukturen denkbar, wie beispielsweise die in Figur 12B dargestellte Gitterstruktur, die hexagonale Strukturen enthält.

Ebenso können, wie in den Figuren 13A und 13B schematisch dargestellt, punktförmige Maskenschichten 10 verwendet werden. Die einzelnen Punkte 11 der Maskenschicht können dabei beliebige geometrische Formen aufweisen, beispielsweise wie in Figur 13A dargestellt eine quadratische Form oder, wie in Figur 13B dargestellt, eine hexagonale Struktur. Alternativ können die Punkte der Maskenschicht 10 zum Beispiel runde oder dreieckige Formen aufweisen. Die lateralen Abmessungen der Maskenpunkte 11, zum Beispiel die Kantenlängen bei einer quadratischen oder rechteckigen Form der Maskenpunkte 11, betragen vorzugsweise 5 µm oder weniger.

Die in den Figuren 13A und 13B dargestellten punktförmigen Maskenschichten können insbesondere bei einer Anwendung des erfindungsgemäßen Verfahrens bei der Herstellung von Lumineszenzdioden eingesetzt werden.

Die beigefügten Patentansprüche 1-29 geben den Gegenstand an, für den Schutz begehrt wird.

## Patentansprüche

1. Verfahren zum lateralen Zertrennen eines Halbleiterwafers, der ein Aufwachssubstrat (2) und eine Halbleiterschichtenfolge (3) enthält, mit den Verfahrensschritten:
- Bereitstellen eines Aufwachssubstrats (2),
- Epitaktisches Aufwachsen einer Halbleiterschichtenfolge (3), die eine funktionelle Halbleiterschicht (5) umfasst, auf das Aufwachssubstrat (2),
- Aufbringen einer Maskenschicht (10) auf Teilbereiche der Halbleiterschichtenfolge (3) zur Erzeugung maskierter Bereiche (11) und unmaskierter Bereiche (12),
- Implantation von Ionen durch die unmaskierten Bereiche (12) zur Erzeugung von Implantationsbereichen (13) in dem Halbleiterwafer (1), und
- Zertrennen des Halbleiterwafers (1) entlang der Implantationsbereiche (13), wobei die Implantationsbereiche (13) in einer als Trennschicht (4) vorgesehenen Schicht der Halbleiterschichtenfolge (3) angeordnet sind, und wobei das Aufwachssubstrat (2) oder zumindest ein Teil des Aufwachssubstrats (2) von dem Halbleiterwafer abgetrennt wird,
**dadurch gekennzeichnet, dass** die Halbleiterschichtenfolge (3) vor der Ionenimplantation derart strukturiert wird, dass sie Gräben (19) aufweist, in denen die Trennschicht (4) freigelegt ist.

2. Verfahren nach Anspruch 1,
**dadurch gekennzeichnet, dass**
bei der Ionenimplantation Wasserstoffionen, Heliumionen, Wasserstoffionen und Heliumionen, oder Wasserstoffionen und Borionen implantiert werden.

3. Verfahren nach Anspruch 1 oder 2,
**dadurch gekennzeichnet, dass**
das Zertrennen mittels einer Temperaturbehandlung erfolgt.

4. Verfahren nach Anspruch 3,
**dadurch gekennzeichnet, dass**
die Temperaturbehandlung bei einer Temperatur im Bereich von 300 °C bis 1200 °C erfolgt.

5. Verfahren nach einem der vorhergehenden Ansprüche,
**dadurch gekennzeichnet, dass**
die Halbleiterschichtenfolge (3) auf einem Nitridverbindungshalbleitermaterial basiert.

6. Verfahren nach einem der vorhergehenden Ansprüche,
**dadurch gekennzeichnet, dass**
die funktionelle Halbleiterschicht (5) eine strahlungsemittierende Schicht oder eine strahlungsdetektierende Schicht ist.

7. Verfahren nach einem der vorhergehenden Ansprüche,
**dadurch gekennzeichnet, dass**
die funktionelle Halbleiterschicht (5) InₓAl_{y}Ga_{1-x-y}N mit 0 ≤ x ≤ 1, 0 ≤ y ≤ 1 und x+y ≤ 1, aufweist.

8. Verfahren nach einem der vorhergehenden Ansprüche,
**dadurch gekennzeichnet, dass**
das Aufwachssubstrat (2) ein GaN-Substrat oder ein AlN-Substrat ist.

9. Verfahren nach einem der vorhergehenden Ansprüche,
**dadurch gekennzeichnet, dass**
die maskierten Bereiche (11) der Halbleiterschichtenfolge (3) in zumindest einer lateralen Richtung eine Abmessung (b) von 20 µm oder weniger aufweisen.

10. Verfahren nach einem der vorhergehenden Ansprüche,
**dadurch gekennzeichnet, dass**
die Trennschicht (4) zumindest ein Element enthält, das eine größere Kernladungszahl als Gallium aufweist.

11. Verfahren nach Anspruch 10,
**dadurch gekennzeichnet, dass**
die Trennschicht (4) Indium enthält.

12. Verfahren nach einem der vorhergehenden Ansprüche,
**dadurch gekennzeichnet, dass**
die Halbleiterschichtenfolge (3) mindestens eine der Trennschicht (4) benachbarte Diffusionsbarriereschicht (8, 9) für die implantierten Ionen enthält.

13. Verfahren nach Anspruch 12,
**dadurch gekennzeichnet, dass**
die Diffusionsbarriereschicht (8, 9) eine mit Zn, Si oder Fe dotierte Nitridverbindungshalbleiterschicht ist.

14. Verfahren nach Anspruch 12 oder 13,
**dadurch gekennzeichnet, dass**
die Halbleiterschichtenfolge (3) beidseits der Trennschicht (4) Diffusionsbarriereschichten (8, 9) für die implantierten Ionen enthält.

15. Verfahren nach einem der vorhergehenden Ansprüche,
**dadurch gekennzeichnet, dass**
die Trennschicht (4) eine tensil verspannte Schicht ist.

16. Verfahren nach Anspruch 15,
**dadurch gekennzeichnet, dass**
die tensil verspannte Trennschicht (4) eine Nitridverbindungshalbleiterschicht ist, die Aluminium enthält.

17. Verfahren nach Anspruch 15 oder 16,
**dadurch gekennzeichnet, dass**
die tensil verspannte Trennschicht (4) eine Si-dotierte Nitridverbindungshalbleiterschicht ist.

18. Verfahren nach einem der vorhergehenden Ansprüche,
**dadurch gekennzeichnet, dass**
die Trennschicht (4) eine durch laterales epitaktisches Überwachsen (ELOG) hergestellte Halbleiterschicht ist.

19. erfahren nach Anspruch 18,
**dadurch gekennzeichnet, dass**
vor dem Aufwachsen der Trennschicht (4) eine ELOG-Maskenschicht (27) auf das Aufwachssubstrat (2) aufgebracht wird, deren Struktur zumindest teilweise mit der Struktur der Maskenschicht (10) übereinstimmt.

20. Verfahren nach einem der vorhergehenden Ansprüche,
**dadurch gekennzeichnet, dass**
die Trennschicht (4) aus einem Halbleitermaterial gebildet ist, in dem die implantierten Ionen einen größeren Diffusionskoeffizienten als in einer an die Trennschicht (4) angrenzenden Schicht aufweisen.

21. Verfahren nach Anspruch 20,
**dadurch gekennzeichnet, dass**
die Trennschicht (4) eine p-dotierte Nitridverbindungshalbleiterschicht ist.

22. Verfahren nach einem der vorhergehenden Ansprüche,
**dadurch gekennzeichnet, dass**
der Halbleiterwafer (1) vor dem Zertrennen an einer von dem Aufwachssubstrat (2) abgewandten Oberfläche mit einem Trägersubstrat (15) verbunden wird.

23. Verfahren nach Anspruch 22,
**dadurch gekennzeichnet, dass**
vor dem Verbinden des Halbleiterwafers (1) mit dem Trägersubstrat (15) eine planarisierende Zwischenschicht (16) auf die Maskenschicht (10) aufgebracht wird.

24. Verfahren nach Anspruch 22,
**dadurch gekennzeichnet, dass**
vor dem Verbinden des Halbleiterwafers (1) mit dem Trägersubstrat (15) eine Zwischenschicht (17) auf die unmaskierten Bereiche (12) des Halbleiterwafers (1) aufgebracht wird, deren Dicke größer als die Dicke der Maskenschicht (10) ist.

25. Verfahren nach Anspruch 22,
**dadurch gekennzeichnet, dass**
die Maskenschicht (10) vor dem Verbinden des Halbleiterwafers (1) mit dem Trägersubstrat (15) entfernt wird.

26. Verfahren nach einem der vorhergehenden Ansprüche,
**dadurch gekennzeichnet, dass**
durch die Strukturierung eine Lumineszenzdiodenstruktur oder Laserdiodenstruktur erzeugt wird.

27. Verfahren nach Anspruch 26,
**dadurch gekennzeichnet, dass**
eine Streifenlaserstruktur (21) erzeugt wird.

28. Verfahren nach Anspruch 27,
**dadurch gekennzeichnet, dass**
die Streifenlaserstruktur (21) eine Streifenbreite (d) zwischen einschließlich 1,5 µm und einschließlich 3 µm aufweist.

29. Verfahren nach einem der vorhergehenden Ansprüche,
**dadurch gekennzeichnet, dass**
die Maskenschicht (22) die durch die Strukturierung erzeugte Struktur (21) umhüllt.

## Claims

1. Method for laterally dividing a semiconductor wafer containing a growth substrate (2) and a semiconductor layer sequence (3), comprising the method steps of:
- providing a growth substrate (2),
- epitaxially growing a semiconductor layer sequence (3), which comprises a functional semiconductor layer (5), onto the growth substrate (2);
- applying a mask layer (10) to partial regions of the semiconductor layer sequence (3) in order to produce masked regions (11) and unmasked regions (12),
- implanting ions through the unmasked regions (12) in order to produce implantation regions (13) in the semiconductor wafer (1), and
- dividing the semiconductor wafer (1) along the implantation regions (13), wherein the implantation regions (13) are arranged in a layer of the semiconductor layer sequence (3) which is provided as a separating layer (4), and
wherein the growth substrate (2) or at least one part of the growth substrate (2) is separated from the semiconductor wafer,
**characterized in that**
the semiconductor layer sequence (3) is patterned prior to the ion implantation in such a way that it has trenches (19) in which the separating layer (4) is uncovered.

2. Method according to claim 1,
**characterized in that**
hydrogen ions, helium ions, hydrogen ions and helium ions, or hydrogen ions and boron ions are implanted during the ion implantation.

3. Method according to claim 1 or 2,
**characterized in that**
dividing is effected by means of a thermal treatment.

4. Method according to claim 3,
**characterized in that**
the thermal treatment is effected at a temperature within the range of 300°C to 1200°C.

5. Method according to one of the preceding claims,
**characterized in that**
the semiconductor layer sequence (3) is based on a nitride compound semiconductor material.

6. Method according to one of the preceding claims,
**characterized in that**
the functional semiconductor layer (5) is a radiation-emitting layer or a radiation-detecting layer.

7. Method according to one of the preceding claims,
**characterized in that**
the functional semiconductor layer (5) has InₓAl_{y}Ga_{1-x-y}N where 0 ≤ x ≤ 1, 0 ≤ y ≤ 1 and x+y ≤ 1.

8. Method according to one of the preceding claims,
**characterized in that**
the growth substrate (2) is a GaN substrate or an AlN substrate.

9. Method according to one of the preceding claims,
**characterized in that**
the masked regions (11) of the semiconductor layer sequence (3) have a dimension (b) of 20 µm or less in at least one lateral direction.

10. Method according to one of the preceding claims,
**characterized in that**
the separating layer (4) contains at least one element which has a higher atomic number than gallium.

11. Method according to claim 10,
**characterized in that**
the separating layer (4) contains indium.

12. Method according to one of the preceding claims,
**characterized in that**
the semiconductor layer sequence (3) contains at least one diffusion barrier layer (8, 9) - adjacent to the separating layer (4) - for the implanted ions.

13. Method according to claim 12,
**characterized in that**
the diffusion barrier layer (8, 9) is a nitride compound semiconductor layer doped with Zn, Si or Fe.

14. Method according to claim 12 or 13,
**characterized in that**
the semiconductor layer sequence (3) contains diffusion barrier layers (8, 9) for the implanted ions on both sides of the separating layer (4).

15. Method according to one of the preceding claims,
**characterized in that**
the separating layer (4) is a tensile-stressed layer.

16. Method according to claim 15,
**characterized in that**
the tensile-stressed separating layer (4) is a nitride compound semiconductor layer containing aluminum.

17. Method according to claim 15 or 16,
**characterized in that**
the tensile-stressed separating layer (4) is an Si-doped nitride compound semiconductor layer.

18. Method according to one of the preceding claims,
**characterized in that**
the separating layer (4) is a semiconductor layer produced by lateral epitaxial overgrowth (ELOG).

19. Method according to claim 18,
**characterized in that**
prior to growing the separating layer (4), an ELOG mask layer (27) is applied to the growth substrate (2), the structure of said ELOG mask layer at least partly corresponding to the structure of the mask layer (10).

20. Method according to one of the preceding claims,
**characterized in that**
the separating layer (4) is formed from a semiconductor material in which the implanted ions have a greater diffusion coefficient than in a layer adjoining the separating layer (4).

21. Method according to claim 20,
**characterized in that**
the separating layer (4) is a p-doped nitride compound semiconductor layer.

22. Method according to one of the preceding claims,
**characterized in that**
the semiconductor wafer (1) is connected to a carrier substrate (15) prior to dividing at a surface remote from the growth substrate (2).

23. Method according to claim 22,
**characterized in that**
prior to connecting the semiconductor wafer (1) to the carrier substrate (15), a planarizing interlayer (16) is applied to the mask layer (10).

24. Method according to claim 22,
**characterized in that**
prior to connecting the semiconductor wafer (1) to the carrier substrate (15), an interlayer (17) is applied to the unmasked regions (12) of the semiconductor wafer (1), the thickness of said interlayer being greater than the thickness of the mask layer (10).

25. Method according to claim 22,
**characterized in that**
the mask layer (10) is removed prior to connecting the semiconductor wafer (1) to the carrier substrate (15).

26. Method according to one of the preceding claims,
**characterized in that**
a luminescent diode structure or laser diode structure is produced by the patterning.

27. Method according to claim 26,
**characterized in that**
a stripe laser structure (21) is produced.

28. Method according to claim 27,
**characterized in that**
the stripe laser structure (21) has a stripe width (d) of between 1.5 µm and 3 µm inclusive.

29. The method according to one of the preceding claims,
**characterized in that**
the mask layer (22) envelops the structure (21) produced by the patterning.

## Revendications

1. Procédé pour séparer latéralement une plaquette de semi-conducteurs, qui contient un substrat de croissance (2) et une suite de couches de semi-conducteurs (3), avec les étapes de procédé suivantes:
- préparation d'un substrat de croissance (2),
- croissance épitaxiale d'une suite de couches de semi-conducteurs (3) qui comprend une couche fonctionnelle de semi-conducteurs (5), sur le substrat de croissance (2),
- application d'une couche de masques (10) sur des zones partielles de la suite de couches de semi-conducteurs (3) pour produire des zones masquées (11) et des zones non masquées (12),
- implantation d'ions à travers les zones non masquées (12) pour produire des zones d'implantation (13) dans la plaquette de semi-conducteurs (1), et
- séparation de la plaquette de semi-conducteurs (1) le long des zones d'implantation (13), les zones d'implantation (13) étant disposées dans une couche prévue en tant que couche de séparation (4) de la suite de couches de semi-conducteurs (3) et
le substrat de croissance (2) ou au moins une partie du substrat de croissance (2) étant séparé(e) de la plaquette de semi-conducteurs, **caractérisé en ce que** la suite de couches de semi-conducteurs (3) est structurée avant l'implantation d'ions de telle manière qu'elle comporte des cavités (19) dans lesquelles la couche de séparation (4) est libérée.

2. Procédé selon la revendication 1, **caractérisé en ce que** des ions d'hydrogène, d'hélium, des ions d'hydrogène et d'hélium ou des ions d'hydrogène et de bore sont implantés lors de l'implantation d'ions.

3. Procédé selon la revendication 1 ou 2, **caractérisé en ce que** la séparation a lieu au moyen d'un traitement thermique.

4. Procédé selon la revendication 3, **caractérisé en ce que** le traitement thermique a lieu à une température allant de 300° C à 1200° C.

5. Procédé selon l'une quelconque des revendications précédentes, **caractérisé en ce que** la suite de couches de semi-conducteurs (3) est basée sur un matériau semi-conducteur de composé à base de nitrure.

6. Procédé selon l'une quelconque des revendications précédentes, **caractérisé en ce que** la couche fonctionnelle de semi-conducteurs (5) est une couche émettant un rayonnement ou une couche détectant un rayonnement.

7. Procédé selon l'une quelconque des revendications précédentes, **caractérisé en ce que** la couche fonctionnelle de semi-conducteurs (5) comporte de 1' InₓAl_{y}Ga_{1-x-y}N avec 0 ≤ x ≤ 1, 0 ≤ y ≤ 1 et x+y ≤ 1.

8. Procédé selon l'une quelconque des revendications précédentes, **caractérisé en ce que** le substrat de croissance (2) est un substrat GaN ou un substrat AlN.

9. Procédé selon l'une quelconque des revendications précédentes, **caractérisé en ce que** les zones masquées (11) de la suite de couches de semi-conducteurs (3) comportent dans au moins une direction latérale une dimension (b) de 20 µm ou moins.

10. Procédé selon l'une quelconque des revendications précédentes, **caractérisé en ce que** la couche de séparation (4) contient au moins un élément qui comporte un nombre atomique plus grand que le gallium.

11. Procédé selon la revendication 10, **caractérisé en ce que** la couche de séparation (4) contient de l'indium.

12. Procédé selon l'une quelconque des revendications précédentes, **caractérisé en ce que** la suite de couches de semi-conducteurs (3) contient au moins une couche barrière de diffusion (8, 9) voisine de la couche de séparation (4) pour les ions implantés.

13. Procédé selon la revendication 12, **caractérisé en ce que** la couche barrière de diffusion (8, 9) est une couche de semi-conducteurs d'un composé à base de nitrure dotée de Zn, Si ou Fe.

14. Procédé selon la revendication 12 ou 13, **caractérisé en ce que** la suite de couches de semi-conducteurs (3) contient des deux côtés de la couche de séparation (4) des couches barrières de diffusion (8, 9) pour les ions implantés.

15. Procédé selon l'une quelconque des revendications précédentes, **caractérisé en ce que** la couche de séparation (4) est une couche contrainte en tension.

16. Procédé selon la revendication 15, **caractérisé en ce que** la couche de séparation contrainte en tension (4) est une couche de semi-conducteurs de composé à base de nitrure qui contient de l'aluminium.

17. Procédé selon la revendication 15 ou 16, **caractérisé en ce que** la couche de séparation contrainte en tension (4) est une couche de semi-conducteurs de composé à base de nitrure dotée de Si.

18. Procédé selon l'une quelconque des revendications précédentes, **caractérisé en ce que** la couche de séparation (4) est une couche de semi-conducteurs fabriquée par surcroissance latérale épitaxiale (ELOG).

19. Procédé selon la revendication 18, **caractérisé en ce qu'**avant la croissance de la couche de séparation (4) une couche de masques ELOG (27) est appliquée au substrat de croissance (2), dont la structure coïncide au moins en partie avec la structure de la couche de masques (10).

20. Procédé selon l'une quelconque des revendications précédentes, **caractérisé en ce que** la couche de séparation (4) est formée d'un matériau semi-conducteur dans lequel les ions implantés présentent un coefficient de diffusion plus grand que dans une couche limitrophe de la couche de séparation (4).

21. Procédé selon la revendication 20, **caractérisé en ce que** la couche de séparation (4) est une couche de semi-conducteurs de composé à base de nitrure dotée p.

22. Procédé selon l'une quelconque des revendications précédentes, **caractérisé en ce que** la plaquette de semi-conducteurs (1) est reliée avant la séparation à un substrat de support (15) sur une surface opposée au substrat de croissance (2).

23. Procédé selon la revendication 22, **caractérisé en ce qu'**une couche intermédiaire planarisante (16) est appliquée sur la couche de masques (10) avant la liaison de la plaquette de semi-conducteurs (1) avec le substrat de support (15).

24. Procédé selon la revendication 22, **caractérisé en ce qu'**une couche intermédiaire (17) est appliquée sur les zones non masquées (12) de la plaquette de semi-conducteurs (1) avant la liaison de la plaquette de semi-conducteurs (1) avec le substrat de support (15), dont l'épaisseur est plus grande que l'épaisseur de la couche de masques (10).

25. Procédé selon la revendication 22, **caractérisé en ce que** la couche de masques (10) est enlevée avant la liaison de la plaquette de semi-conducteurs (1) avec le substrat de support (15).

26. Procédé selon l'une quelconque des revendications précédentes, **caractérisé en ce qu'**une structure à diodes électroluminescentes ou une structure à diodes laser est produite par la structuration.

27. Procédé selon la revendication 26, **caractérisé en ce qu'**une structure à laser à bande (21) est produite.

28. Procédé selon la revendication 27, **caractérisé en ce que** la structure à laser à bande (21) comporte une largeur de bande (d) entre 1,5 µm inclus et 3 µm inclus.

29. Procédé selon l'une quelconque des revendications précédentes, **caractérisé en ce que** la couche de masques (22) enveloppe la structure (21) produite par la structuration.
